# EUROPEAN PATENT APPLICATION

(11) **EP 4 611 177 A1**
(43) Date of publication of application: **03.09.2025**
(21) Application number: 25160445.0
(22) Date of filing: 27.02.2025
(51) Int. Cl.: H01R 4/48, H01R 13/6583, H05K 9/00, H01R 13/24

(54) **CONTACTING ASSEMBLY**

(30) Priority: 01.03.2024 DE 102024106044
(71) Applicant: TE Connectivity Solutions GmbH, 8200 Schaffhausen (CH)
(72) Inventor: IVANOV, Ivan, 8200 Schaffhausen (CH); FERTIG, Jochen, 8200 Schaffhausen (CH); BUCHHOLZ, Ron Eric, 8200 Schaffhausen (CH); SCHWINDT, Jens, 8200 Schaffhausen (CH); BURGHARD, Michael, 8200 Schaffhausen (CH)
(74) Representative: Grünecker Patent- und Rechtsanwälte PartG mbB

(57) **Abstract**

Contacting assembly (1) for arrangement between two electrical components (82). The objective of the invention is to provide a contacting assembly (1) that is easy to manufacture and to install. The invention satisfies the objective by manufacturing a contacting assembly (1) for arrangement between two electrical components (82), which comprises a carrier (4) and at least one contact spring unit (2), wherein the at least one contact spring unit (2) comprises a holding section (50) and contact spring tongues (38), wherein the contact spring tongues (38) extend from opposite sides (20) of the carrier (4) and are connected with each other via the holding section (50) and wherein the holding section (50) clasps the carrier (4) in sections and is frictionally held on the carrier (4).

## Description

Contacting assembly for arrangement between two electrical components, wherein the contacting assembly comprises a carrier and at least one contact spring unit, wherein the at least one contact spring unit comprises a holding section and contact spring tongues and is frictionally held on the carrier.

Contacting assemblies with contact spring units are used, for example, to establish an electrical contact and to shield electrical components against electromagnetic interferences.

Such contacting assemblies can, for example, be constructed monolithically. However, a monolithic design usually lacks the flexibility to adapt to a mounting surface. Therefore, in addition to the monolithically constructed component, other components such as spacer sleeves are often required, which eliminates the one-piece structure and the associated advantages and increases costs again. The selection of materials is limited due to the manufacturing method.

In another typical manufacturing method for a contacting assembly, individual contact springs are inserted into a carrier using stitching. Although the carrier may be made of a different material than the contact springs, the insertion of individual contact springs is, however, complex and highly dependent on the - usually delicate - geometries of the mating pair when using a stitching machine. Furthermore, additional design elements are required for stitching, which further increases the complexity of the design, in particular the contact spring design. Another disadvantage of a stitching design is the often inadequate electromagnetic compatibility.

The problem underlying the invention is to provide a contacting assembly that is easy to manufacture and assemble.

The present invention solves this problem by manufacturing a contacting assembly for arrangement between two electrical components, comprising a carrier and at least one contact spring unit, wherein the at least one contact spring unit comprises a holding section and contact spring tongues, and wherein the contact spring tongues extend from opposite sides of the carrier and are connected with each other via the holding section, and wherein the holding section clasps the carrier in sections and is frictionally held on the carrier.

Furthermore, the problem is solved by an arrangement with such a contacting assembly and two electrical components, wherein the contacting assembly is located between the two electrical components in the operating state, wherein the contact spring tongues of the two electrical components are elastically, in particular predominantly elastically, deformed towards the carrier and press the holding section against the carrier and the clamping force applied by the holding section to the carrier is thus increased.

These solutions allow an easy assembly and manufacturing of the contacting assembly, which, compared to stitching, requires no additional tools and no tight tolerances, which increases efficiency and reduces costs. The solutions mentioned are suitable for use in both manual and automated processes and allow more flexibility in the selection of materials for the carrier and contact spring unit, as well as for mounting the contacting assembly on any mounting surface as a monolithic design.

The invention can be further improved by the following configurations, each of which is preferred on its own and can be arbitrarily combined with each other.

In a preferred embodiment, the carrier can be plate-shaped. In this case, the carrier can be configured in particular as a plate or a disc. The carrier can be arbitrarily adapted in its form to a predetermined mounting surface and provided with recesses and mounting holes, such as holes that accept screw, pin and/or rivet connections or serve to save material, which allows a high degree of flexibility in the design and adaptation of the carrier to different applications. Likewise, the carrier can be preferably designed as a frame to save material and weight and, for example, have at least one large through-opening in the center. In particular, this allows further configurations and constellations of the contacting assembly with other assemblies, for example, an assembly can be provided within the frame.

The carrier can be made of one material or a combination of different materials and, in particular, can have a different material from the contact spring unit. For example, the carrier can be made of an electrically non-conductive plastic.

An injection molding process can be used to manufacture the carrier, which reduces production costs.

The section of the carrier that is clasped by the holding section can be a flange section that is formed by an edge of the carrier and extends away from a center section of the carrier. In this case, the flange section can have a smaller material thickness than the area of the carrier adjacent to the center of the carrier, in order to be mounted more easily and to reduce the space required.

To enable a high degree of flexibility and adaptability to a wide range of applications, the carrier sides, in particular all four narrow sides of the carrier, can be used for attaching contact spring units. Likewise, the flat sides of the carrier can be used for attaching contact spring units.

The contact spring unit can be pushed onto the flange section. Likewise, the contact spring unit can be pressed onto the flange section to establish a secure and backlash-free connection.

Alternatively, the contact spring unit can have a clamp connection with the flange section and be clamped with clamping elements such as screws or wedges, which offers the advantage of easy adjustability. A clamp connection with clamping lugs is also possible.

The contact spring unit can be configured as a contact spring strip and can have a plurality of contact spring tongues or, equivalently, contact spring lamellae, in particular in a monolithic design. In one configuration, the contact spring tongues are arranged next to one another. The contact spring strip can be a stamped and bent part. The plurality of contact spring tongues can be in pairs opposite one another.

The contact spring unit can have a band-shaped or, equivalently, strip-shaped material connection that connects the contact spring tongues to one another. The material connection can extend in particular along the carrier, in particular along the edge or the flange section. The material connection can particularly extend along the edge or the flange section that is clasped by the holding section. The material connection prevents interruptions between the individual contact spring tongues, which increases the electromagnetic compatibility of such an assembly when installed compared to stitching. The material connection ensures the structural integrity of the contact spring unit.

The contact spring strip can have any number of contact spring tongues. The number of contact spring tongues depends in particular on the respective application.

For easy manufacturing of the contact spring unit, the holding section can be configured to be continuous, i.e. uninterrupted. The holding section can also be provided with material interruptions between two contact spring tongues arranged next to each other in order to reduce the force required for pressing on.

The holding section of the contact spring unit can have two opposing legs in cross-section. At their ends located towards the center section of the carrier, the legs of the holding section can each merge into a contact spring tongue. This transition of the legs of the holding section to one contact spring tongue each can be made in a radius. Alternatively, the transition can be bent or kinked. This monolithic design is stable under mechanical loads or vibrations.

The legs of the holding section can be formed by the material connection. Alternatively, the holding section can also be constructed from individual clamping sections that extend away from the material connection and are each spaced apart from one another in the direction along the material connection. Each of these clamping sections can continue into a contact spring tongue. In this case, the clamping sections can run parallel to one another.

The holding section can have a U-, V-, C- or at least an approximately omega-shaped cross-section. For example, the material connection can be bent into a U-, V-, C- or at least an approximately omega-shape.

To ensure sufficient pressing on the flange section, the holding section can have a clear width that is smaller in the force-free state than a material thickness of the carrier in the area clasped by the holding section. It is preferred if the holding section is bent beforehand, creating a preload that allows a lower contact pressure.

The at least two contact spring tongues of the contact spring unit can be elastically deflected and can be located opposite each other with respect to the flange section. The free ends of the contact spring tongues can, in this case, point away from the center section of the carrier and be spaced apart from the holding section. The directed force presses the contact spring tongues and the holding section connected to them against the carrier.

The contact spring tongues can be arranged alternately above and below the carrier or in pairs opposite each other along the edge of the carrier.

Above and below the carrier or on both sides of the material connection, the contact spring tongues can have the same length. Alternatively, the contact spring tongues that extend on one side of the carrier or material connection can have a different length than the contact spring tongues that extend on the other side of the carrier, which is preferred for meeting predetermined space requirements and for compensating manufacturing and/or assembly tolerances.

In addition to the frictional connection, the carrier can be connected to the contact spring unit via a form-fit connection. For this purpose, the contact spring unit can be provided with at least one form-fit element. At least one form-fit element of the form-fit connection can, for example, be formed by the carrier edge and be in engagement or be brought into engagement with the at least one form-fit element of the at least one contact spring unit.

In one configuration, the form-fit element of the carrier can be located on the flange section. The at least one form-fit element of the contact spring unit can be part of the contact spring strip. This form-fit connection can be completely decoupled from the functional connection between the contact spring unit and the carrier and can be used, for example, as assembly protection for transporting the contacting assembly. In particular, the form-fit element of the contact spring unit can be formed by the material connection.

In a further configuration, the carrier can have spacers that extend away from at least one of the two flat sides of the carrier. In one configuration, the spacers cannot protrude beyond the contact spring tongues in the direction pointing away from the respective flat side in the force-free state. The spacers can minimize overloading of the contact spring tongues and prevent the contact spring tongues from being compressed too far. The spacers can thus act as an overstretch protection for the contact spring tongues.

Furthermore, the at least one spacer can be configured as contact force limitation, which limits the contact force of a contact spring tongue to a certain amount or range, which is reached at the level of the spacer.

In a preferred embodiment, the contacting assembly can comprise a plurality of contact spring strips that are arranged next to one another and/or on two opposite narrow sides of the carrier, spaced apart from one another. It is also conceivable that the contact spring strips are arranged in multiple rows on the carrier and that the contact spring strips are arranged on at least one or on two or more sides of the carrier that are not opposite one another.

Another configuration provides for the arrangement of the contacting assembly and two electrical components. In the assembled state, the contacting assembly can be located between the two electrical components. The contact spring tongues can be elastically, in particular predominantly elastically, deformed from the two electrical components towards the carrier. The holding section of the contact spring units is pressed against the carrier. This increases the clamping force applied by the holding section to the carrier. As a result, the frictional engagement is increased in a preferred manner.

In the following, the invention is described by way of example with reference to the drawings based on several embodiments. In doing so, the same reference signs are always used in the drawings for elements that correspond to one another in terms of function and/or structure.

In accordance with the description above, a feature of the embodiment can be omitted if the technical effect associated with that feature is not important for a particular application. Conversely, a feature not yet present can also be added to the embodiment in accordance with the description above if the technical effect of the feature to be added is important for a particular application.

It is shown by:
- Fig. 1: an illustration of the contacting assembly;
- Fig. 2: a side view of a contact spring unit with the holding section between the two contact spring tongues;
- Fig. 3: an illustration of the contacting assembly with the configuration of the spacer;
- Fig. 4: an illustration of the contacting group with a frame as carrier;
- Fig. 5: an illustration of the arrangement of the contacting assembly between two electrical components; and
- Fig. 6: an illustration of the contacting assembly with contact spring units on all narrow sides.

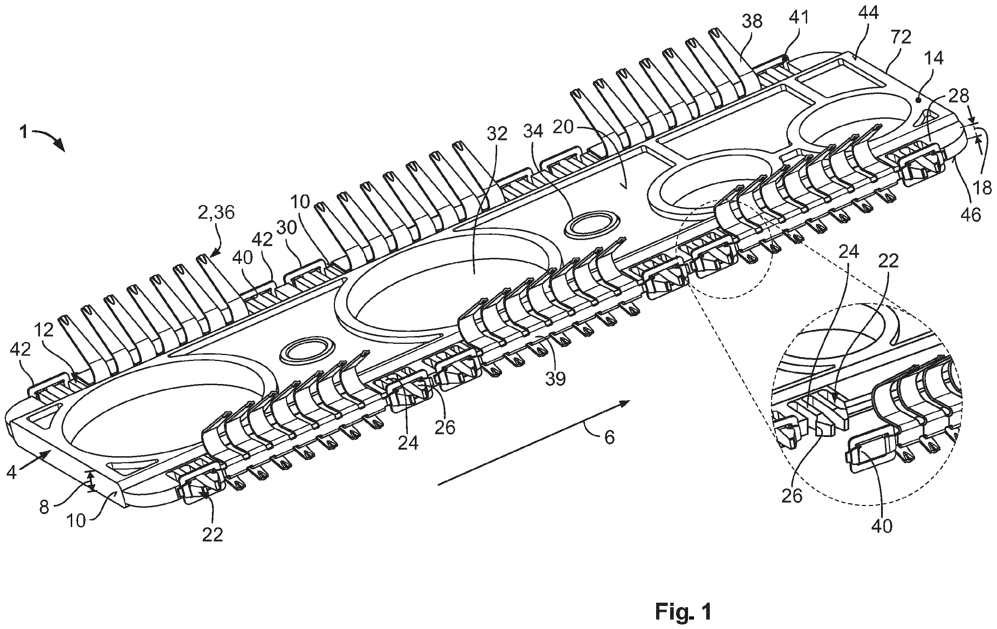

Fig. 1 shows the contacting assembly 1 with contact spring units 2 mounted on a carrier 4.

In this preferred embodiment, the carrier 4 is configured merely exemplarily as a plate. In one direction 6, the carrier 4 is extended longer than in the other directions and has a material thickness 8, which forms the narrow sides 10 of the carrier 4. In this illustration, the material thickness 8 in the center of the carrier or the center section 14 of the carrier 4 is exemplarily characterized. The material thickness 8 of the carrier 4 can be different over the entire carrier 4. In the direction of one or the longitudinal extension 6 of the carrier 4, the carrier 4 can have several flanks or, equivalently, flange sections 12 along the narrow sides 10, which extend away from the center section 14 of the carrier 4. A further configuration can provide a continuous flange section 12 over the entire narrow side 10 of the carrier 4 for each narrow side. The at least one flange section 12 can thereby have a smaller thickness or material thickness 18 than the center section 14 of the carrier 4.

Manufacturing of the contact spring unit 2 and carrier 4 can be done separately and thus both units can be made of different materials. In one embodiment, the carrier 4 can be configured as a cast part. It is also conceivable to use an electrically non-conductive plastic as a material for the carrier 4, since the carrier 4 does not necessarily have to be conductive - this increases flexibility during manufacturing and reduces costs.

The at least one contact spring unit 2 is pressed onto the flange section 12 of the carrier 4. The flange sections 12 may be chamfered and/or rounded to simplify assembly. Another preferred configuration could provide for the attachment of contact spring units 2 over the flat sides 20 of the carrier 4. Of course, the at least one contact spring unit 2 can also be pressed directly onto the carrier 4 if there is no flange section 12.

Instead of being pressed on, the at least one contact spring unit 2 can also be connected to the flange section 12 of the carrier 4 by means of a clamp connection and clamped with clamping elements such as screws or wedges.

Furthermore, the flange sections 12 can be interrupted by form-fit elements 22. The form-fit elements 22 can be configured such that they protrude away from the narrow side 10 of the carrier 4, perpendicular to the direction of the longitudinal extension 6, and each have two elastically deflectable arms 24, each with a latching protrusion 26. Other embodiments of the form-fit elements 22 can have, for example, clamping lugs or latching hooks.

The form-fit elements 22 of the carrier 4 can be attached in pairs to the carrier edge 28 and form the form-fit counterpart for a contact spring unit 2. In this case, the form-fit elements 22 can be configured such that they are each engaged with a complementary form-fit element 30 of the contact spring unit 2 and are spaced apart from one another. In one configuration, the form-fit element 22 can also be positioned on the shorter narrow side 10 of the carrier 4. The complementary form-fit element 30 of the contact spring unit 2 can accordingly be engaged with at least one form-fit element 22 on the shorter narrow side 10 of the carrier 4.

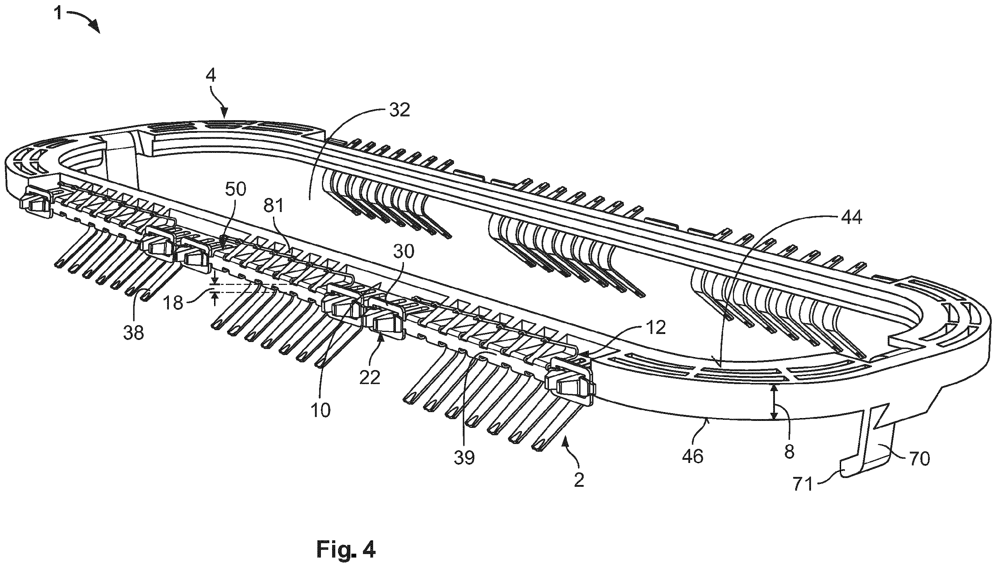

The carrier 4 can have an arbitrary number and size of recesses 32 for, for example, plug or screw connections and/or to save material. The shape of the carrier 4 can be arbitrarily adapted to the respective mounting surface. One possible configuration provides at least one recess 32 for at least one mounting bush 34 that can be used for screw connections. For example, the carrier 4 can be configured as a frame surrounding a central opening (Fig. 4).

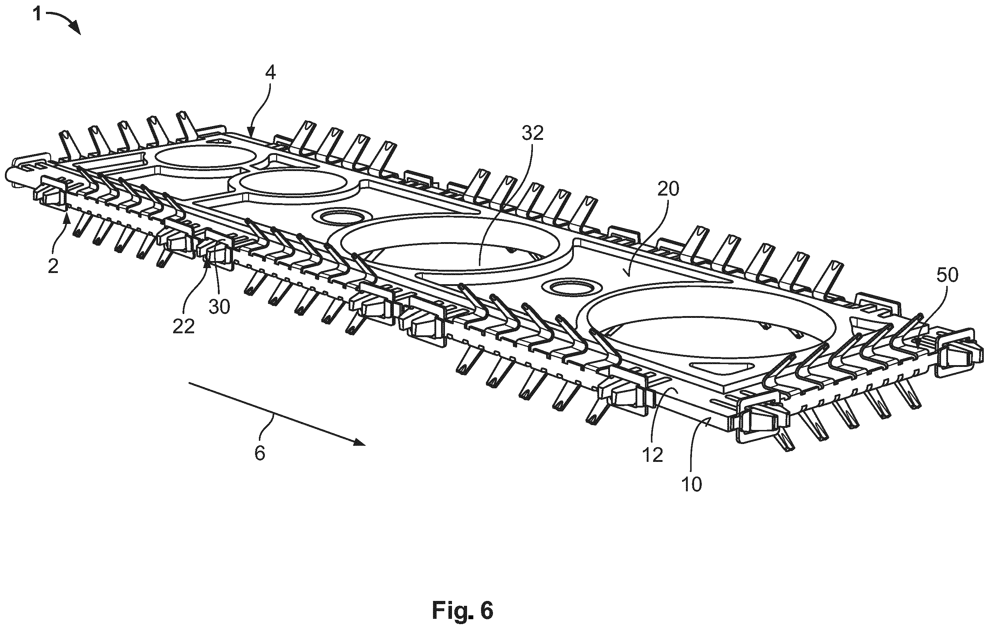

Several contact spring units 2 can be clipped onto the carrier 4 along at least one narrow side 10 running in the direction of the longitudinal extension 6. Of course, the carrier 4 can also be configured to be square and have one or more contact spring units 2 along each of the four sides, in particular the four narrow sides 10. In Fig. 1, several contact spring units 2 are arranged next to each other on the two opposite longer narrow sides 10, with each contact spring unit 2 being located opposite a contact spring unit 2 on the other narrow side 10. It is also possible that on all four narrow sides 10 of the carrier 4 contact spring units 2 are attached (Fig. 6), which can be arranged next to each other, but also on top of each other.

The contact spring unit 2 can be configured as an elongated contact spring strip 36, as shown in Fig. 1, the longitudinal direction of which runs parallel here to the direction of the longitudinal extension 6. The contact spring unit 2 can be configured monolithically. The contact spring strip 36 can, for example, be configured as a stamped and bent part.

The contact spring strip 36 has several contact spring tongues - or, equivalently, contact spring lamellae - 38 arranged next to each other along its longitudinal direction. The number of contact spring tongues 38 can be arbitrarily adapted to the respective needs and requirements. The contact spring tongues 38 can be connected by means of a material connection 39 that extends along the longitudinal direction of the contact spring strip 36. In a preferred configuration, the material connection 39 can extend along the flange section 12 of the carrier 4. In this case, the material connection 39 can be configured in the form of a band or a strip. At their one end, the contact spring tongues 38 are connected to the material connection 39; the other end of the contact spring tongues 38 is configured as a free, resilient end.

The at least one form-fit element 30 of such a contact spring strip 36 can have an opening 40. The opening 40 can, for example, be surrounded by a rectangular frame 41 at the end 42 of the contact spring strip 36. The frame 41 can, in particular, be located at one end of the material connection 39.

In this context, the opening 40 points away from the carrier narrow side 10. The opening should be large enough to receive the form-fit element 22 of the carrier 4 and to latch it in the frame 41, as shown in this embodiment in Fig. 1. Another preferred configuration provides for a further opening 40 at the other end 42 of the contact spring strip 36 along the narrow side 10 in the direction of the longitudinal extension 6 of the carrier 4, which may be configured symmetrically to the other opening 40. Of course, other configurations of complementary form-fit elements on carrier 4 and contact spring strip 36 are also possible. For example, the edges of the material connection 39 can be clipped into the latching tongues of the carrier 4.

One possible embodiment of the contact spring strip 36 provides two opposing contact spring lamellae or tongues 38 pointing in opposite directions, which point away from the respective flat sides 20 of the carrier 4 and can be elastically deflected. Here, as in the rest of the text, an "elastic" deflection describes any deflection with elastic components. The respective contact spring tongues 38 can be configured symmetrically with respect to the direction of the longitudinal extension 6 or, however, can be asymmetrical, for example, having a longer contact spring tongue 38 on the carrier upper side 44 than on the carrier lower side 46.

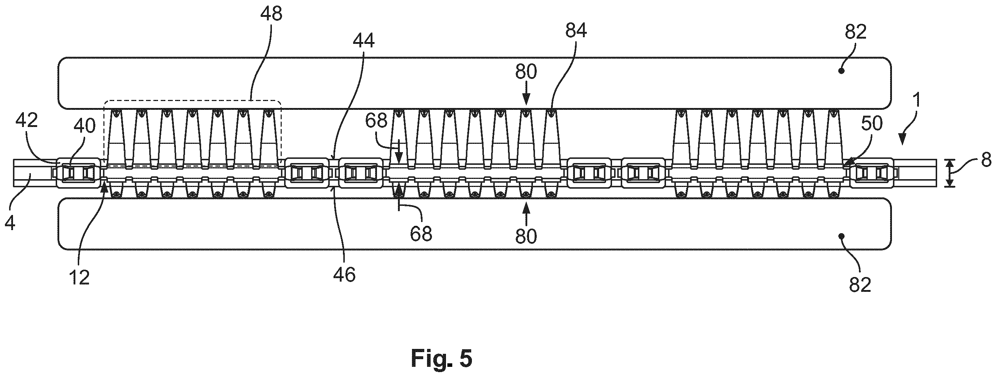

In a further preferred configuration, for example, one row 48 (Fig. 5) of the contact spring tongues 38 pointing in the same direction on the carrier upper side 44 can be offset with respect to the other row 48 of contact spring tongues 38 on the carrier lower side 46, so that between two contact spring tongues 38 pointing in the same direction on the carrier upper side 44, on the opposite carrier side 46, one contact spring tongue 38 points in the opposite direction. The contact spring tongues 38 above 44 and below 46 of the carrier 4 are therefore arranged alternately. The row 48 can be a contact spring package or a contact spring magazine.

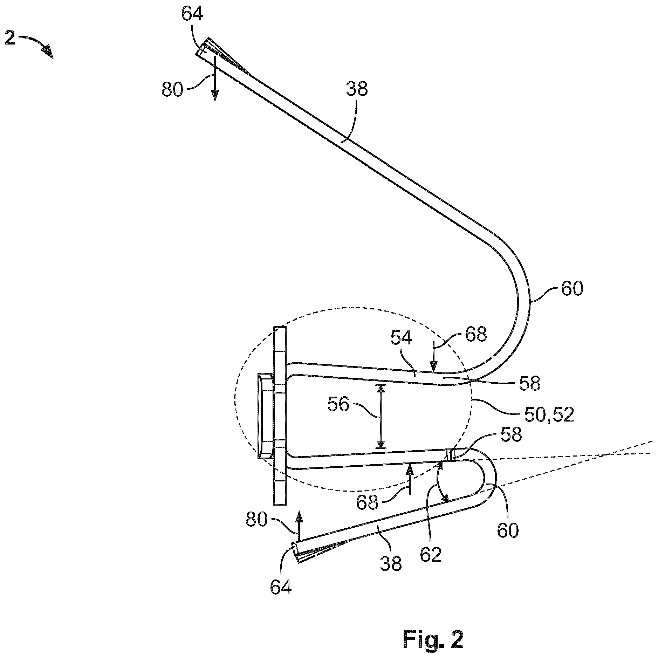

The contact spring tongues 38 above 44 and below 46 of the carrier 4 are connected to one another by means of a holding section 50 (Fig. 2), which is located between the two opposing contact spring tongues 38. The material connection 39 can be part of the holding section 50.

Fig. 2 shows a contact spring unit 2 and illustrates the configuration of the contact spring tongues 38 with the holding section 50.

The holding section 50 has a U-shaped cross-section 52, the open side of which points to the flange section 12 of the carrier 4 or the carrier center section 14 (Fig. 1). The two legs 54 of the U-shaped cross-section 52 lie opposite each other. In this case, the holding section 50 can have a clear width 56 that is less than the material thickness 18 of the carrier 4 in the area that is clasped by the holding section 50.

At either end 58 of the U-shaped cross-section 52, the holding section 50 can have a bend 60 that merges smoothly into one contact spring tongue 38 each. The bend, or equivalently, the arcuate deflection 60 positions the respective contact spring tongue 38 at an acute angle 62 to the connected leg 54 of the U-shaped cross-section 52 and thus to the flat side 20 or flange section 12 of the carrier 4, which later rests against the leg 54. The free end 64 of the respective contact spring tongue 38 can point away from the carrier center section 14 and be spaced apart from the holding section 50.

The contact spring tongues 38 located opposite one another with respect to the holding section 50 are preferably configured symmetrically and extend at the same angle 62 from the respective carrier flat side 20 or the holding section 50. An asymmetrical configuration is also possible. In this way, the contact spring tongues 38 can be shorter on one side of the holding section 50 than on the opposite side of the holding section 50, as shown in Fig. 4. The longer contact spring tongues 38 and their greater free spring travel can be used to compensate for coarser manufacturing and/or assembly tolerances when assembling with other electrical components 82. In this case, the shorter contact spring tongue 38 can extend at a smaller angle 62 from the holding section 50 than the longer contact spring tongue 38 on the opposite side.

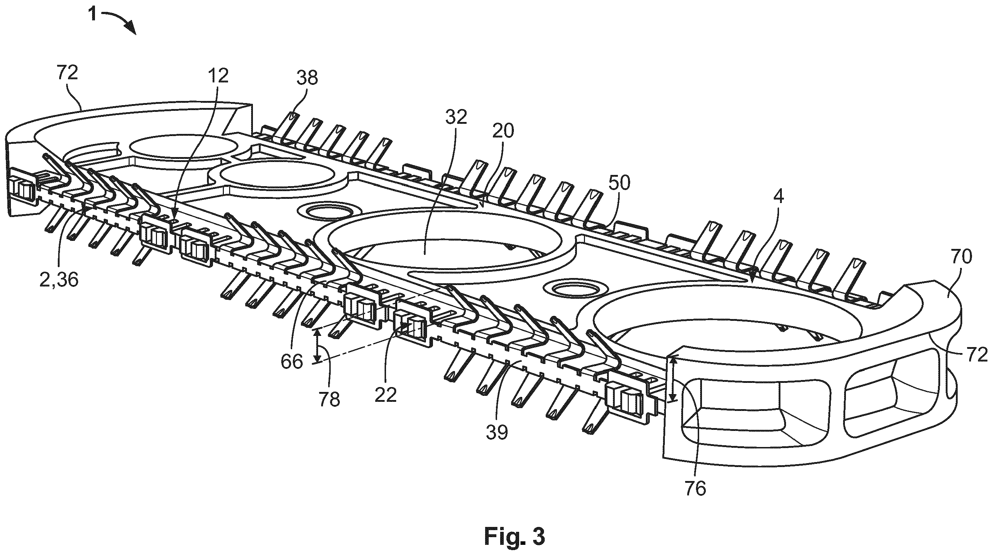

The holding section 50 encompasses the flange section 12 of the carrier 4 and is frictionally connected to the flange section 12 of the carrier 4, as shown in Fig. 3. If the contact spring unit 2 is configured as a contact spring strip 36 as described above, the contact spring tongues 38 arranged next to one another form a holding section 50 which extends in the longitudinal direction of the contact spring strip 36 and into which the flange section 12 can be inserted.

Fig. 3 shows the contacting assembly 1 with contact spring tongues 38 and, in the embodiment with spacers 70 at each shorter end 72 of the carrier 4.

Another configuration provides for an interruption of the holding section 50 on the flat sides 20 or on the flange section 12 of the carrier 4 between contact spring tongues 38 arranged next to each other. In this way, the width of the bending edge of the contact spring unit 2 is preferably reduced. The holding section 50 can already be bent before assembly and thus have a pretension, as a result of which no large press-on force is necessary during assembly. The clamping force 68 (Fig. 5) generated after assembly presses the contact spring unit 2 onto the carrier 4.

Furthermore, the carrier 4 can comprise spacers 70 that point away from the flat sides 20 of the carrier 4. The spacers 70 can be part of a monolithic configuration of the carrier 4.

The spacers 70 can protrude perpendicularly to the respective flat side 20. The height 76 of the spacers 70 thereby does not exceed the height 78 of the protruding contact spring tongues 38 in the force-free state. Preferably, the height 76 is smaller than the height 78. The spacers 70 prevent the contact spring tongues 38 from being compressed too far. This prevents the contact spring tongues 38 from being overloaded. The spacers 70 can thus be an overstretch protection for the contact spring tongues 38.

Another configuration provides that the height 76 of the spacer 70 corresponds to the height 78 of the compressed contact spring tongues 38, in which a predetermined contact force 80 is generated (Figs. 2 and 5). The spacer 70 can thus be used as a contact force limitation.

Fig. 4 shows a configuration of the contacting assembly 1 with a frame-shaped carrier 4.

The carrier 4 can have an essentially oval base area with a recess 32 that can completely penetrate the carrier 4. Other embodiments can provide an angular, for example rectangular or square, or a circular frame as a carrier 4. The material thickness or material strength 8 can be the same over the entire carrier 4.

In the embodiment shown, the carrier 4 has a flange section 12 with form-fit elements 22 that are in engagement with the complementary form-fit elements 30 of the contact spring units 2. Analogous to the other embodiments, the respective flange section 12 of the carrier 4 can have a lower thickness or material strength 18.

The contact spring units 2 are arranged along the two opposite longer narrow sides 10 of the carrier 4. The flange section 12 can have ribs 81, which each protrude between the individual contact spring tongues 38 of a contact spring unit 2 on the carrier upper side 44 of the flange section 12 perpendicularly to the carrier upper side 44 upwards and become steeper towards the carrier center 14. In an alternative embodiment, the ribs 81 can also protrude downwards from the carrier lower side 46, in particular from the flange section 12, perpendicularly to the carrier lower side 46.

The spacers 70 can be formed on only one side of the carrier 4, for example on the carrier lower side 46. The spacers 70 can also each have a latching hook 71, with which the carrier 4 can be attached to a mounting surface (not shown). In one configuration, there should be at least two latching hooks 71 to secure the entire assembly during storage and transportation.

Fig. 5 shows the arrangement of the contacting assembly 1 with two interfaces, such as two electrical components 82.

In the operating state, the contacting assembly 1 can be mounted between two further electrical components 82, as shown in Fig. 5, wherein the contact spring tongues 38, which protrude away from the carrier upper side 44 and carrier lower side 46, press with a contact force 80 (see also

Fig. 2) against the respective complementary contacts 84 of the two electrical components 82. As soon as the complementary contacts 84 press on the contact spring tongues 38, the holding section 50 of the contact spring units 2 is pressed against the carrier 4 and the clamping force 68 (Fig. 2) is thus increased once again. The portion of the clamping force 68 that is exerted by the contact force 80 generated by the contact spring tongues 38 may be greater or smaller than the portion of the clamping force 68 that is exerted by the holding section 50 prior to assembly.

Fig. 6 shows an alternative embodiment with a carrier 4 and contact spring units 2 on all four narrow sides 10 of the carrier 4.

In this configuration, the carrier 4 is an elongated plate with flange sections 12 on each of the four narrow sides 10. The flat sides 20 of the carrier 4 are perforated by recesses 32.

Along the longer narrow sides 10, a plurality of contact spring units 2 are attached in a row in the direction of the longitudinal extension 6, spaced apart from one another, wherein the at least one holding section 50 of the respective contact spring unit 2 holds the contact spring unit 2 on the flange section 12 of the carrier 4. In addition, the contact spring units 2 are secured to the carrier 4 by form-fit elements 22 of the carrier 4, which protrude away from the flange section 12 perpendicular to the narrow side 10 and engage with complementary form-fit elements 30 of the contact spring units 2, on the carrier 4.

Along the shorter narrow sides 10, one contact spring unit 2 is held on the carrier 4 in each case. Here, too, form-fit elements 22 protrude away from the carrier 4 perpendicular to the corresponding narrow side 10. A configuration with several contact spring units 2 on the shorter narrow side 10 is also possible.

### Reference Signs

- 1: contacting assembly
- 2: contact spring unit
- 4: carrier
- 6: direction of the longitudinal extension
- 8: material thickness of the carrier
- 10: narrow side of the carrier
- 12: flange section
- 14: center section
- 18: material thickness of the flange section
- 20: flat side of the carrier
- 22: form-fit element on the carrier
- 24: elastically deflectable arm
- 26: latching protrusion
- 28: carrier edge
- 30: complementary form-fit element on the contact spring unit
- 32: recess
- 34: mounting bush
- 36: contact spring strip
- 38: contact spring tongue/contact spring lamellae
- 39: material connection
- 40: opening of the contact spring unit
- 41: frame
- 42: end of the contact spring unit
- 44: carrier upper side
- 46: carrier lower side
- 48: row contact spring tongues of one side
- 50: holding section
- 52: U-shaped cross-section
- 54: leg
- 56: clear width
- 58: end of U-shaped cross-section
- 60: bend, arcuate change in geometry
- 62: angle
- 64: end of contact spring tongue
- 66: interruption of holding section
- 68: clamping force
- 70: spacer (overstretch protection)
- 71: latching hook
- 72: shorter end of the carrier
- 76: height of the spacer
- 78: height of the contact spring tongue
- 80: contact force
- 81: rib
- 82: electrical component
- 84: contact of the electrical component

## Claims

1. Contacting assembly (1) for arrangement between two electrical components (82),
wherein the contacting assembly comprises a carrier (4) and at least one contact spring unit (2),
wherein the at least one contact spring unit (2) comprises a holding section (50) and contact spring tongues (38),
wherein the contact spring tongues (38) extend from opposite sides (20) of the carrier (4) and are connected to each other via the holding section (50), and
wherein the holding section (50) clasps the carrier (4) in sections and is frictionally held on the carrier (4).

2. Contacting assembly (1) according to claim 1, wherein the carrier (4) is made of a different material from that of the contact spring unit (2).

3. Contacting assembly (1) according to claim 1 or 2, wherein the clasped section of the carrier (4) is a flange section (12) that is formed by an edge (28) of the carrier (4) and extends from a center section (14) of the carrier (4).

4. Contacting assembly (1) according to claim 3, wherein the contact spring unit (2) is pressed onto the flange section (12).

5. Contacting assembly (1) according to any one of claims 1 to 4, wherein the holding section (50) has two opposing legs (54) which merge at their ends (58), located towards the carrier center section (14), into a respective contact spring tongue (38).

6. Contacting assembly (1) according to any one of claims 1 to 5, wherein the holding section (50) has a clear width (56) which in the force-free state is smaller than a material thickness (18) of the carrier (4) in the area clasped by the holding section (50).

7. Contacting assembly (1) according to any one of claims 1 to 6, wherein the contact spring unit (2) has a band-shaped material connection (39) which extends along the carrier (4) and by which the contact spring tongues (38) are connected to one another.

8. Contacting assembly (1) according to any one of claims 1 to 7, wherein the free ends (64) of the contact spring tongues (38) point away from the carrier center section (14) and are spaced apart from the holding section (50).

9. Contacting assembly (1) according to any one of claims 1 to 8, wherein the contact spring unit (2) is configured as a contact spring strip (36) and has a plurality of contact spring tongues (38) that are arranged next to one another.

10. Contacting assembly (1) according to any one of claims 1 to 9, wherein the contact spring tongues (38) are arranged above (44) and below (46) the carrier (4) alternately or in pairs opposite one another along the carrier edge (28).

11. Contacting assembly (1) according to any one of claims 1 to 10, wherein the carrier (4) has a form-fit connection to the contact spring unit (2) in addition to the frictional connection.

12. Contacting assembly (1) according to claim 11, wherein at least one form-fit element (22) of the carrier (4) is formed by the carrier edge (28) and is in engagement with a complementary form-fit element (30) of the at least one contact spring unit (2).

13. Contacting assembly (1) according to any one of claims 1 to 12, wherein the carrier (4) has at least one spacer (70) on at least one of its two flat sides (20), extending away from the respective flat side (20) of the carrier (4), and the at least one spacer (70) does not protrude beyond the contact spring tongues (38) in the direction pointing away from the respective flat side (20) in the force-free state.

14. Contacting assembly (1) according to any one of claims 9 to 13, wherein the contact spring strips (36) are arranged next to one another and on two opposite narrow sides (10) of the carrier (4), spaced apart from one another.

15. Arrangement comprising a contacting assembly (1) according to any one of claims 1 to 14 and two electrical components (82), wherein the contacting assembly (1) is located between the two electrical components (82) in the operating state, wherein the contact spring tongues (38) of the two electrical components (82) are elastically deformed towards the carrier (4) and press the holding section (50) of the contact spring units (2) against the carrier (4) and the clamping force (68) applied by the holding section (50) to the carrier (4) is thus increased.
